# DEMANDE DE BREVET EUROPEEN

(11) **EP 3 499 677 A1**
(43) Date de publication de la demande: **19.06.2019**
(21) Numéro de dépôt: 18211399.3
(22) Date de dépôt: 10.12.2018
(51) Int. Cl.: H02J 3/38, H01L 31/02, H02J 7/35, H02S 40/38, H01L 31/053, H01M 10/46

(54) **SYSTÈME PHOTOVOLTAÏQUE À BATTERIE INTÉGRÉE ET APPAREIL MOBILE COMPORTANT UN TEL SYSTÈME**

(30) Priorité: 15.12.2017 FR 1762216
(71) Demandeur: Commissariat à l'Energie Atomique et aux Energies Alternatives, 75015 Paris (FR)
(72) Inventeur: RAZONGLES, Guillaume, 11000 CARCASSONNE (FR)
(74) Mandataire: Cabinet Camus Lebkiri

(57) **Abrégé**

L'invention concerne un système photovoltaïque comportant au moins une cellule photovoltaïque (200) et un dispositif de stockage d'énergie (300) relié électriquement à ladite au moins une cellule photovoltaïque (200), dans lequel :
- la cellule photovoltaïque comporte un substrat semiconducteur (210) dont au moins une zone (220) est dopée positivement et une zone est dopée négativement, et
- le dispositif de stockage d'énergie (300) comporte au moins une anode (320), une cathode (310) et des collecteurs d'énergie (330), lesdits collecteurs (330) du dispositif de stockage constituant également les connexions électriques de la cellule photovoltaïque (200) de sorte que le dispositif de stockage d'énergie est en contact avec la cellule photovoltaïque.

## Description

### DOMAINE TECHNIQUE

La présente invention concerne un système photovoltaïque fonctionnant comme générateur de tension. Elle concerne plus particulièrement un système photovoltaïque à batterie intégrée. L'invention concerne également un appareil mobile équipé d'un tel système photovoltaïque.

L'invention trouve des applications dans le domaine de la production d'énergie électrique et, en particulier, dans le domaine de la production d'énergie solaire.

### ETAT DE LA TECHNIQUE

De façon connue en soi, un système photovoltaïque est un système autonome remplissant plusieurs fonctions telles que la conversion de l'énergie solaire en énergie électrique, le stockage de l'énergie électrique et la gestion de l'énergie électrique. Il peut servir à alimenter en courant continu des dispositifs, tels qu'une lampe ou un actionneur, ou être relié à un réseau de distribution électrique.

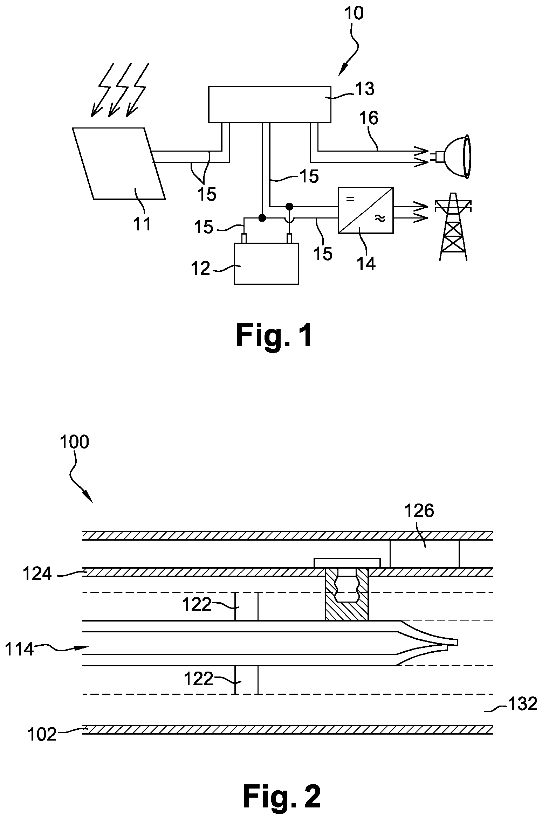

La figure 1 représente de façon schématique un système photovoltaïque 10 selon l'art antérieur. Le système photovoltaïque 100 comporte les éléments suivants :
- un ou plusieurs panneaux photovoltaïques 11, ou panneaux solaires, intégrant une ou plusieurs cellules photovoltaïques, protégées de l'environnement extérieur par un packaging, et convertissant l'énergie solaire en énergie électrique ;
- une ou plusieurs batteries 12, intégrant une ou plusieurs cellules électrochimiques, protégées de l'environnement extérieur par un packaging, stockant l'énergie électrique produite par le ou les panneaux photovoltaïques ;
- une unité de gestion 13, ou régulateur, de l'énergie électrique produite ou stockée ; et éventuellement
- un onduleur 14 pour convertir la tension continue obtenue en sortie de la batterie 12 en une tension alternative correspondant à la tension de fonctionnement du réseau électrique

Ces éléments sont reliés entre eux par des câbles électriques 15 et peuvent être éloignés les uns des autres.

Le régulateur 13 remplit plusieurs fonctions, dont la régulation des charges et des décharges de la batterie 12. Ce régulateur peut notamment être amené à limiter le courant de charge ou de décharge et à interrompre la charge ou la décharge (afin d'éviter une surcharge ou décharge profonde). Il empêche également que la batterie 12 ne se décharge dans les cellules photovoltaïques du panneau 11 en l'absence d'ensoleillement. Il dispose de plusieurs entrées-sorties, dont une entrée couplée au panneau photovoltaïque 11, une première sortie en tension continue (typiquement 12 V ou 24 V) pour le circuit électrique 16 alimentant les divers dispositifs en courant continu et une deuxième sortie (également en tension continue) pour le raccordement de la batterie 12.

Des efforts de miniaturisation ont été réalisés afin de permettre l'utilisation de ces générateurs de tension photovoltaïque à des applications autres que l'habitat. Par exemple, les batteries, traditionnellement de type plomb-acide, ont été remplacées par des batteries plus compactes, à base de lithium notamment.

Le brevet FR2936111 décrit un système photovoltaïque 100 dont le poids et l'encombrement sont réduits grâce à l'intégration de ses composants au sein d'un seul dispositif. Un exemple d'un tel système est représenté sur la figure 2. Dans ce système photovoltaïque, destiné principalement à des habitations, une batterie au lithium 114 a été assemblée au dos du panneau photovoltaïque 102 par l'intermédiaire d'une structure de maintien mécanique122. Un espace 132, aménagé autour de la structure de maintien, et de largeur comprise entre 1 cm et 10 cm, sépare le panneau photovoltaïque 102 de la batterie 114. Cet espace permet une circulation d'air dans le système, afin que la chaleur dégagée par le panneau ne compromette pas la durée de vie de la batterie. Le système photovoltaïque comporte par ailleurs une plaque de support 124 en époxy, disposée à l'opposé du panneau photovoltaïque par rapport à la batterie et sur laquelle repose une carte électronique 126. La carte électronique 126 implémente notamment la gestion de la charge et de la décharge de la batterie. Elle est vissée aux bornes de la batterie à travers la plaque de support.

Le système photovoltaïque 100 du brevet FR2936111, bien que plus compact que le système photovoltaïque 10 de la figure 1, reste volumineux, en raison notamment de l'utilisation d'une structure de maintien qui, toutefois, ne peut être supprimée pour des raisons d'évacuation de la chaleur et, par conséquent, d'élévation importante de la température. L'utilisation du système du brevet FR2936111 est donc limitée à des applications où l'encombrement n'est pas un facteur prépondérant. L'utilisation de ce système n'est, par exemple, pas envisageable pour alimenter des appareils portables.

### RESUME DE L'INVENTION

Pour répondre au problème évoqué ci-dessus de l'encombrement des systèmes photovoltaïques, le demandeur propose un système photovoltaïque dans lequel les collecteurs de la batterie sont aussi les connexions électriques de la cellule photovoltaïque.

Selon un premier aspect, l'invention concerne un système photovoltaïque comportant au moins une cellule photovoltaïque et un dispositif de stockage d'énergie relié électriquement à ladite au moins une cellule photovoltaïque, ladite cellule photovoltaïque comportant un substrat semiconducteur dont au moins une zone est dopée positivement et une zone est dopée négativement. Ce système photovoltaïque se caractérise par le fait que le dispositif de stockage d'énergie comporte au moins une anode, une cathode et des collecteurs d'énergie, lesdits collecteurs du dispositif de stockage constituant également des connexions électriques de la cellule photovoltaïque de sorte que le dispositif de stockage d'énergie soit en contact avec la cellule photovoltaïque.

Le contact physique entre la cellule photovoltaïque et le dispositif de stockage permet une mutualisation des connectiques et du packaging, les deux éléments étant habituellement séparés et protégés de l'environnement séparément. Le système photovoltaïque a ainsi un encombrement réduit par rapport aux systèmes de l'art antérieur.

Dans certains modes de réalisation, les zones dopées de ladite cellule photovoltaïque sont en contact direct avec l'anode et la cathode du dispositif de stockage.

Dans d'autres modes de réalisation, les zones dopées de ladite cellule photovoltaïque sont en contact direct avec les collecteurs d'énergie du dispositif de stockage.

Que les cellules photovoltaïques soient en contact physique avec les collecteurs ou avec l'anode et la cathode du dispositif de stockage, il n'est plus besoin de connexions métalliques pour connecter les zones dopées au dispositif de stockage d'énergie.

De façon avantageuse, les zones dopées de la cellule photovoltaïque sont au moins partiellement recouvertes d'au moins une jonction tunnel. Cette jonction tunnel a l'avantage de séparer chimiquement les zones dopées des électrodes et/ou collecteurs du dispositif de stockage tout en permettant aux électrons de passer dans les électrodes et/ou collecteurs du dispositif de stockage.

Le système photovoltaïque selon l'invention peut comporter une ou plusieurs des caractéristiques suivantes :
- le dispositif de stockage comporte un électrolyte entre l'anode et la cathode, ledit électrolyte s'étendant entre l'anode et la cathode du dispositif de stockage et les zones dopées de la cellule photovoltaïque de sorte à former au moins une jonction tunnel.
- tout ou partie des collecteurs sont positionnés sur une face de la cellule photovoltaïque non-exposée aux rayonnements solaires, cette disposition facilitant la connexion du dispositif de stockage directement sur la cellule photovoltaïque.
- il est fabriqué selon la technologie « Métal Wrap Through (MWT) » ou la technologie « Interdigited Back Contact (IBC) » ou l'une des technologies en couches minces dites top-down (avec la face avant déposée en premier sur le substrat transparent) telles que la technologie au silicium amorphe (a-Si) et la technologie au Tellure de Cadmium (CdTe).
- il comporte au moins une diode anti-retour disposée entre l'anode et/ou la cathode du dispositif de stockage et une zone dopée de la cellule photovoltaïque.
- il comporte un premier et un second types de jonction tunnel et/ou de diode anti-retour, le premier type étant adapté aux zones dopées positivement, le second type étant adapté aux zones dopées négativement.
- il comporte une ou une pluralité de cellules photovoltaïques connectées les unes aux autres et formant un module photovoltaïque.
- la pluralité de cellules photovoltaïques sont connectées en série et seules une première et une seconde cellules de ladite pluralité sont en contact avec le dispositif de stockage.
- un circuit imprimé est intégré dans le module photovoltaïque et met en oeuvre des fonctions électroniques de régulateur.

Selon un second aspect, l'invention concerne un appareil mobile, tel qu'un téléphone mobile ou un ordinateur portable, comportant un système photovoltaïque tel que défini ci-dessus.

Avantageusement, le système photovoltaïque comporte une coque apte à protéger ledit appareil, le système photovoltaïque faisant partie intégrante de ladite coque.

### BREVE DESCRIPTION DES FIGURES

D'autres avantages et caractéristiques de l'invention apparaîtront à la lecture de la description, illustrée par les figures dans lesquelles :
- La figure 1, déjà décrite, représente un exemple de système photovoltaïque selon l'art antérieur.
- La figure 2 déjà décrite, représente un autre exemple de système photovoltaïque selon l'art antérieur.
- Les figures 3 à 18 représentent schématiquement des vues en coupe de différents modes de réalisation du système photovoltaïque selon l'invention.

### DESCRIPTION DETAILLEE D'AU MOINS UN MODE DE REALISATION

Un exemple de réalisation d'un système photovoltaïque dans lequel les collecteurs du dispositif de stockage de l'énergie constituent les connexions électriques des cellules photovoltaïques est décrit en détail ci-après, en référence aux dessins annexés. Cet exemple illustre les caractéristiques et avantages de l'invention. Il est toutefois rappelé que l'invention ne se limite pas à cet exemple.

Sur les figures, les éléments identiques sont repérés par des références identiques. Pour des questions de lisibilité des figures, les échelles de taille entre éléments représentés ne sont pas respectées.

Le système photovoltaïque selon l'invention comporte une ou plusieurs cellules photovoltaïques et un dispositif de stockage de l'énergie produite par le module photovoltaïque.

Le dispositif de stockage d'énergie peut être, par exemple, une batterie, une pile, une capacité, une supercapacité ou tout autre dispositif électrique capable de stocker tout ou partie de l'énergie produite par les cellules photovoltaïques. Le dispositif de stockage d'énergie, appelé indifféremment dispositif de stockage ou batterie, comporte au moins deux électrodes - en particulier une anode et une cathode - et deux collecteurs sensiblement superposés. Selon un ou plusieurs modes de réalisation de l'invention, le dispositif de stockage, ou batterie, est un dispositif à couches minces, cette technologie à couches minces permettant de réaliser une structure plate et peu épaisse dans laquelle des zones d'anode intercalent des zones de cathode. Un contact métallique, appelé collecteur, peut couvrir tout ou partie des zones d'anode et de cathode.

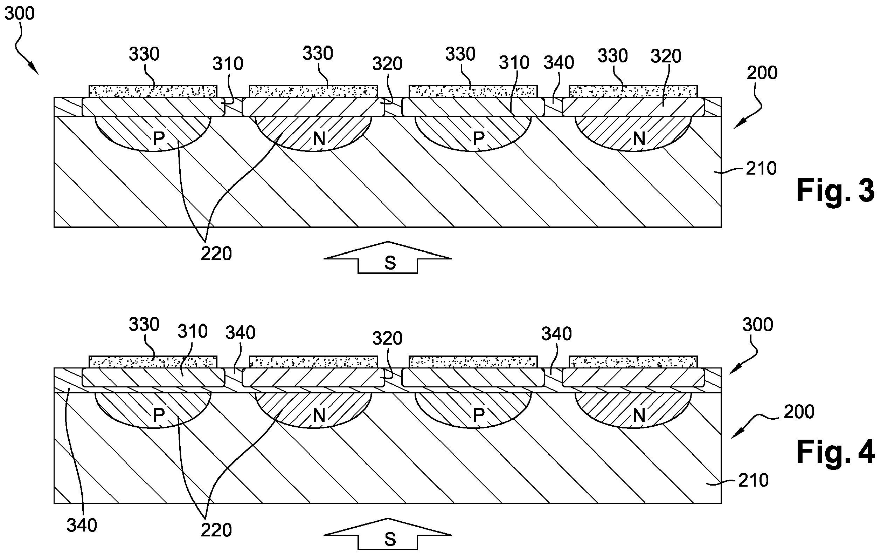

La cellule photovoltaïque comporte un substrat semiconducteur qui reçoit l'énergie solaire, représentée par la flèche S sur les figures 3 - 14, qui est convertie en énergie électrique par les zones dopées. Chaque cellule photovoltaïque est de préférence agencée avec d'autres cellules photovoltaïques identiques de sorte à former un module photovoltaïque. Le système photovoltaïque selon l'invention sera décrit, par la suite, pour une seule cellule photovoltaïque, étant entendu que toute la description du système est identique lorsque plusieurs cellules photovoltaïques sont connectées les unes aux autres et/ou agencées pour former un module photovoltaïque.

Selon l'invention, le dispositif de stockage est en contact, direct ou indirect, avec la cellule photovoltaïque. Le terme « contact, direct ou indirect » s'entend par contact physique entre le dispositif de stockage et la cellule photovoltaïque, ce contact physique permettant le transport des électrons entre la cellule photovoltaïque et le dispositif de stockage. Pour permettre ce contact direct ou indirect, le dispositif de stockage comporte des collecteurs d'énergie qui constituent également les connexions électriques de la cellule photovoltaïque. Autrement dit, des connexions métalliques communes à la batterie et à la cellule photovoltaïque assurent la liaison électrique entre la cellule photovoltaïque et la batterie - sans aucune connectique supplémentaire.

Dans certains modes de réalisation, tel que celui représenté sur la figure 3, le dispositif de stockage est monté directement sur les zones dopées de la cellule photovoltaïque. Dans d'autres modes de réalisation, décrits par la suite, le dispositif de stockage est monté de façon indirecte sur les zones dopées de la cellule photovoltaïque, par exemple par l'intermédiaire d'une jonction tunnel.

La figure 3 représente un exemple du système photovoltaïque selon l'invention. Dans cet exemple, comme dans tous les modes de réalisation décrits par la suite :
▪ la cellule photovoltaïque 200 comporte un substrat semi-conducteur 210, par exemple en silicium, dont plusieurs zones 220 sont dopées. Certaines zones dopées - appelées zones P - sont dopées positivement, d'autres zones dopées - appelées zones N - sont dopées négativement. Dans les exemples des figures 3 à 14, seules deux paires de zones dopées N et P sont représentées ; l'homme du métier comprendra que chaque cellule photovoltaïque peut comporter plus de deux paires de zones dopées ; et
▪ la batterie 300 comporte, d'une part, une anode 320 en contact avec au moins une zone N dopée négativement et, d'autre part, une cathode 310 en contact avec au moins une zone P dopée positivement.

Dans l'exemple de la figure 3, l'anode 320 et la cathode 310 sont en contact direct avec les zones dopées 220. Elles ont chacune une superficie au moins égale à la superficie de la zone dopée 220 qu'elles recouvrent. Les collecteurs 330 de la batterie sont montés sur la surface externe 320a, 310a respectivement de l'anode 320 et de la cathode 310 de sorte à collecter et transporter l'énergie engendrée dans les zones dopées vers une sortie de la batterie (non représentée). Dans cet exemple, un électrolyte 340 assurant les déplacements d'ions au sein de la batterie peut être déposé entre les zones d'anode et de cathode.

Le mode de réalisation de la figure 3, tout comme les modes de réalisation des figures 4 - 7 et 9 - 14, est particulièrement adapté à un positionnement parallèle de la batterie 300 par rapport à la cellule photovoltaïque 200. Un tel positionnement permet d'optimiser l'encombrement engendré par l'ensemble batterie et cellule photovoltaïque.

Dans les exemples des figures 4, 5 et 6, l'anode 320 et la cathode 310 sont en contact indirect avec les zones dopées 220, en particulier si les électrodes 310, 320 de la batterie sont chimiquement incompatibles avec les zones dopées 220 de la cellule photovoltaïque. En effet, dans ces exemples, le système photovoltaïque comporte au moins une jonction tunnel 350. Une jonction tunnel est une fine barrière isolante déposée entre les électrodes (anode et cathode) de la batterie et les zones dopées N et P de la cellule photovoltaïque, au travers de laquelle l'énergie électrique circule par effet tunnel. La jonction tunnel 350 est donc déposée entre l'électrode de la batterie et la zone dopée correspondante de la cellule photovoltaïque, les collecteurs 330 de la batterie étant déposés sur la face de l'anode 320/cathode 310 opposée à la jonction tunnel 350 et l'électrolyte 340 étant déposé entre les zones d'anode et de cathode.

La jonction tunnel 350 peut être formée par l'électrolyte 340 de la batterie. Pour cela, une couche de l'électrolyte 340 séparant l'anode 320 et la cathode 310 peut être déposée sur toute la surface des zones dopées 220 de sorte à éviter un contact direct entre les électrodes de la batterie et les zones dopées, comme représenté sur la figure 4.

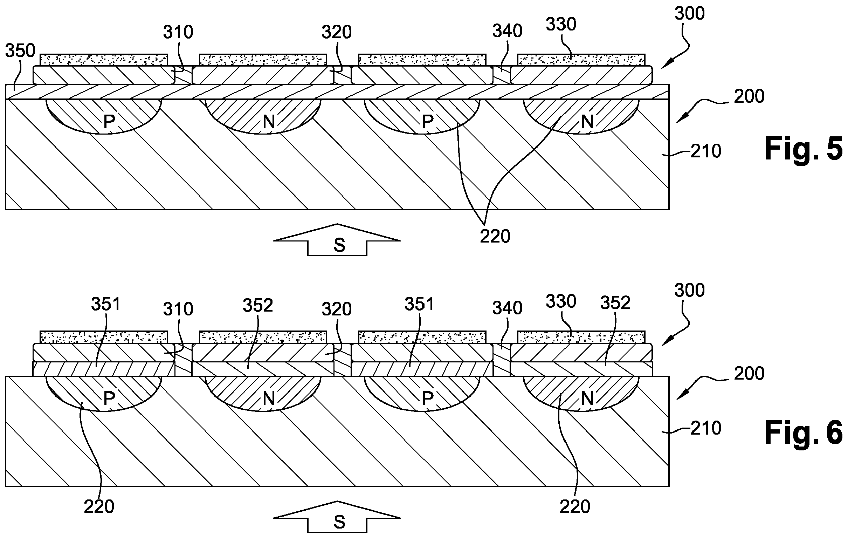

La jonction tunnel 350 peut également être formée par une couche d'un matériau diélectrique tel que de l'oxyde de silicium ou du nitrure de silicium, comme dans l'exemple de la figure 5. Si le matériau diélectrique utilisé comme jonction tunnel n'est pas compatible avec les deux polarités (polarité positive de la zone dopée P et polarité négative de la zone dopée N), alors deux jonctions tunnels en matériaux différents peuvent être déposées, d'une part, une jonction tunnel 351 entre la cathode 310 et la zone dopée P et, d'autre part, une jonction tunnel 352 entre l'anode 320 et la zone dopée N, comme représenté sur la figure 6.

Dans une variante, chaque jonction tunnel peut être remplacée par une diode anti-retour adéquate.

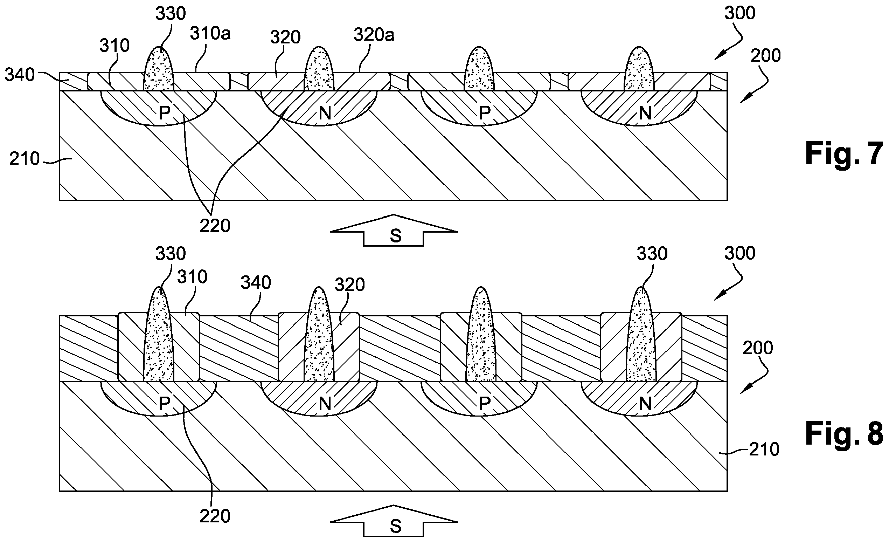

Dans les exemples des figures 7 à 11, les collecteurs 330 de la batterie 300 sont déposés au sein des électrodes 310, 320 de sorte à être en contact direct avec les zones dopées 220 de la cellule photovoltaïque. Autrement dit, chaque collecteur 330 est déposé sur une zone dopée 220 de façon à traverser l'anode 320 ou la cathode 310 et à déboucher à la surface de ladite anode ou de ladite cathode. Dans ces modes de réalisation, chaque collecteur 330 se présente sous la forme d'une couche de matière conductrice, par exemple métallique, d'épaisseur supérieure à l'épaisseur des électrodes 310, 320 et de superficie inférieure à la superficie des zones dopées 220 et des électrodes 310, 320. Ainsi, à la fois le collecteur 330 et l'électrode 310 ou 320 sont en contact avec une des zones dopées 220. De plus, comme le collecteur 330 débouche au-dessus de la surface externe 310a, 320a respectivement de l'électrode 310 ou 320, son rôle de transport de l'énergie de la cellule photovoltaïque vers la sortie de la batterie est assuré.

Dans certains modes de réalisation, comme celui représenté sur la figure 7, l'anode 320 et la cathode 310 recouvrent la totalité des zones dopées 220, l'électrolyte 340 de la batterie s'étendant entre lesdites anode et cathode 320, 310.

Dans d'autres modes de réalisation, comme celui représenté sur la figure 8, l'anode 320 et la cathode 310 ne recouvrent que partiellement les zones dopées 220 de la cellule photovoltaïque. L'électrolyte 340 s'étendant entre les électrodes 320 et 310 peut alors être en contact avec une partie des zones dopées et, par exemple, remplacer une jonction tunnel lorsque l'électrolyte joue le même rôle d'isolation qu'une jonction tunnel. De tels modes de réalisation sont particulièrement adaptés à un positionnement perpendiculaire de la batterie 300 par rapport à la cellule photovoltaïque 200. Un tel positionnement peut être avantageux dans certains dispositifs.

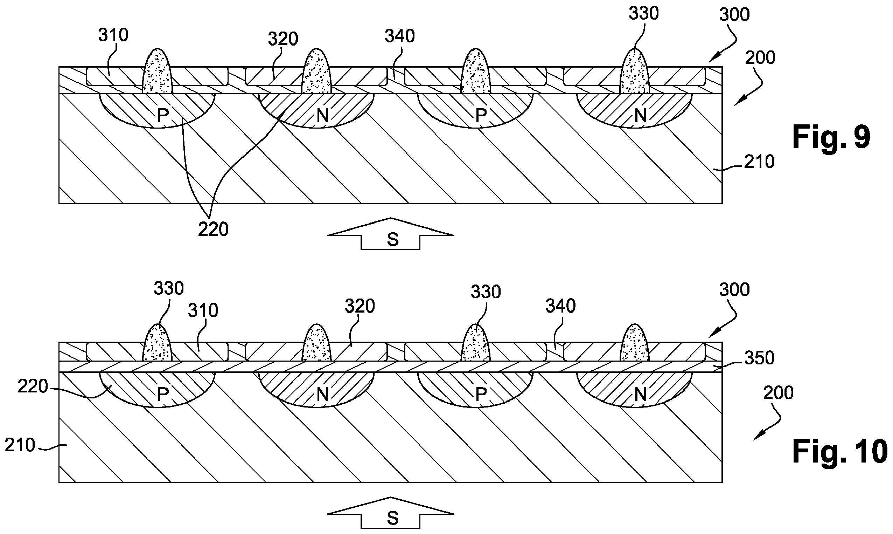

Dans certains modes de réalisation, comme ceux des figures 9 à 11, il peut être avantageux que l'anode 320 et la cathode 310 soient en contact indirect avec les zones dopées 220, en particulier si les électrodes 310, 320 de la batterie sont chimiquement incompatibles avec lesdites zones dopées 220 de la cellule photovoltaïque. Pour cela, le système photovoltaïque peut comporter une ou plusieurs jonctions tunnels 350. Une jonction tunnel 350 est alors déposée entre l'électrode de la batterie et la zone dopée correspondante de la cellule photovoltaïque.

La jonction tunnel 350 peut être formée par l'électrolyte 340 de la batterie. Pour cela, une couche de l'électrolyte 340 séparant l'anode 320 et la cathode 310 peut être déposée sur toute la surface des zones dopées 220 de sorte à éviter un contact direct entre les électrodes de la batterie et les zones dopées, comme représenté sur la figure 9. La jonction tunnel est alors traversée par les collecteurs 330 de la batterie de sorte que lesdits collecteurs 330 soient en contact direct avec les zones dopées 220.

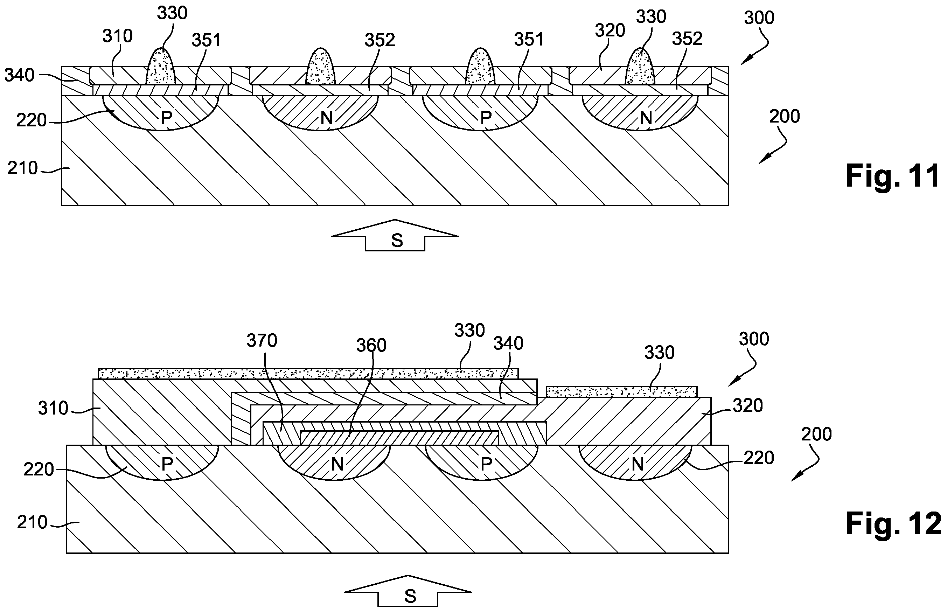

La jonction tunnel 350 peut également être formée par une couche d'un matériau diélectrique tel que ceux cités précédemment, comme dans l'exemple de la figure 10. Si le matériau diélectrique utilisé comme jonction tunnel n'est pas compatible avec les deux polarités (polarité positive de la zone dopée P et polarité négative de la zone dopée N), alors deux jonctions tunnels en matériaux différents peuvent être déposées : une première jonction tunnel 351 est déposée entre la cathode 310 et la zone dopée P et une seconde jonction tunnel 352 est déposée entre l'anode 320 et la zone dopée N, comme représenté sur la figure 11.

Dans une variante, chaque jonction tunnel peut être remplacée par une diode anti-retour adéquate.

Dans les exemples des figures 12 à 14, les différentes cellules photovoltaïques sont connectées en série les unes aux autres. Les zones dopées 220 des différentes cellules photovoltaïques sont donc connectées en série les unes aux autres de sorte que l'énergie engendrée par les différentes zones dopées peut être collectée sur uniquement deux zones dopées, par exemple les zones dopées de collecte 221 et 222.

Dans ces modes de réalisation, seules les zones dopées de collecte 221 et 222 assurent la liaison électrique avec la batterie 300. Pour cela, les zones dopées de collecte 221 et 222 sont en contact - direct ou indirect - avec, respectivement, l'anode 320 et la cathode 310. Une des zones dopées de collecte est une zone dopée négativement ; l'autre zone dopée de collecte est une zone dopée positivement. Les zones dopées 220, ainsi que les zones dopées de collecte, sont connectées les unes aux autres par des liaisons conductrices 360. Ces liaisons conductrices peuvent être formées, par exemple, de couches métalliques déposées à la surface des zones dopées de sorte à connecter lesdites zones dopées entre elles. L'énergie générée par chacune de ces zones dopées 220 peut ainsi être transportée jusqu'aux zones dopées de collecte 221 et 222. Une couche de matériau isolant 370, par exemple de l'oxyde de silicium ou du nitrure de silicium, couvre l'ensemble des zones dopées 220 (excepté les zones dopées de collecte 221, 222) et des liaisons conductrices 360.

Dans l'exemple de la figure 12, l'anode 320 et la cathode 310 sont en contact direct avec les zones dopées de collecte 221, 222. L'anode 320 recouvre non seulement la zone dopée de collecte 221 mais également la couche isolante 370. En particulier, l'anode 320 enveloppe la couche isolante 370 de sorte que ladite couche isolante ne soit en contact avec aucun matériau de la batterie 300 autre que l'anode. Ainsi, l'électrolyte 340 qui s'étend entre l'anode 320 et la cathode 310 n'est en contact physique ni avec la couche isolante 370, ni avec les liaisons conductrices 360.

En outre, dans cet exemple de la figure 12, la cathode 310 recouvre la zone dopée de collecte 222 ainsi que l'électrolyte 340. Les collecteurs 330 de la batterie sont déposés sur la face externe (à savoir la face opposée à la face en contact avec les zones dopées 221, 222) de chacune des électrodes 320, 310 de sorte à transporter l'énergie collectée dans les zones dopées de collecte 221, 222 vers la sortie de la batterie.

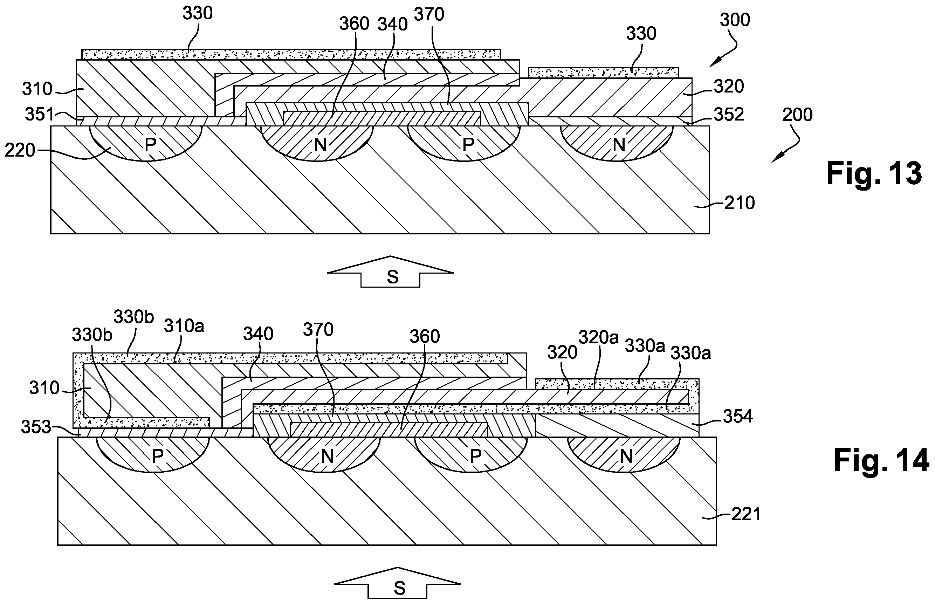

Dans certains modes de réalisation, comme ceux des figures 13 et 14, il peut être avantageux que l'anode 320 et la cathode 310 soient en contact indirect avec les zones dopées de collecte 221, 222, en particulier si les électrodes 310, 320 de la batterie sont chimiquement incompatibles avec lesdites zones dopées 221, 222 de la cellule photovoltaïque. Pour cela, le système photovoltaïque peut comporter une ou plusieurs jonctions tunnels 350. Une jonction tunnel 350 est alors déposée entre l'électrode 310, 320 de la batterie et la zone dopée de collecte correspondante.

La jonction tunnel 350 peut être formée par une couche d'un matériau diélectrique, tel que ceux cités précédemment, déposée entre, d'une part, l'anode 320 et la zone dopée de collecte 221 et, d'autre part, la cathode 310 et la zone dopée de collecte 222. Si le matériau diélectrique utilisé comme jonction tunnel n'est pas compatible avec les deux polarités (polarité positive de la zone dopée P et polarité négative de la zone dopée N), alors deux jonctions tunnels en matériaux différents peuvent être déposées : une première jonction tunnel 351 est déposée entre la cathode 310 et la zone dopée P et une seconde jonction tunnel 352 est déposée entre l'anode 320 et la zone dopée N, comme représenté sur la figure 13.

Dans une variante, chaque jonction tunnel 351, 352 peut être remplacée par une diode anti-retour adéquate. Par exemple, les jonctions tunnel 350 peuvent être remplacées par des diodes anti-retour. Dans l'exemple de la figure 14, une première diode anti-retour 353 est déposée entre la cathode 310 et la zone dopée P et une seconde diode anti-retour 354 est déposée entre l'anode 320 et la zone dopée N, comme représenté sur la figure 13

Comme indiqué précédemment, dans les modes de réalisation des figures 12 et 13, les collecteurs 330 de la batterie sont déposés sur la face externe de l'anode 320 et la face externe de la cathode 310. La face interne des électrodes 310, 320 est ainsi en contact direct ou indirect - via une jonction tunnel - avec les zones dopées de collecte 222, 221.

Dans d'autres modes de réalisation, comme celui représenté sur la figure 14, les collecteurs 330 de la batterie sont en contact avec les zones dopées par l'intermédiaire des jonctions tunnels 350 ou des diodes anti-retours. Dans une variante non représentée, les collecteurs 330 peuvent également être en contact direct avec les zones dopées 221, 222 (sans jonction tunnel). Dans ces modes de réalisation, les collecteurs 330 sont des couches métalliques entourant partiellement l'anode 320 et la cathode 310. En particulier, le collecteur 330a entoure la surface de l'anode 320 qui n'est pas en contact physique avec l'électrolyte 340. Ce collecteur 330a recouvre donc la couche isolante 370, la diode anti-retour 354 et la surface externe 320a de l'anode 320. De façon sensiblement symétrique, le collecteur 330b entoure la surface de la cathode 310 qui n'est pas en contact physique avec l'électrolyte 340. Ce collecteur 330b recouvre donc la couche isolante 370, la diode anti-retour 353 et la surface externe 310a de la cathode 310.

Les modes de réalisation des figures 12 à 14 permettent une fabrication plus aisée du système photovoltaïque puisque la batterie 300 est constituée d'un empilement partiel ou total de plusieurs couches déposées à la surface de la cellule photovoltaïque 200.

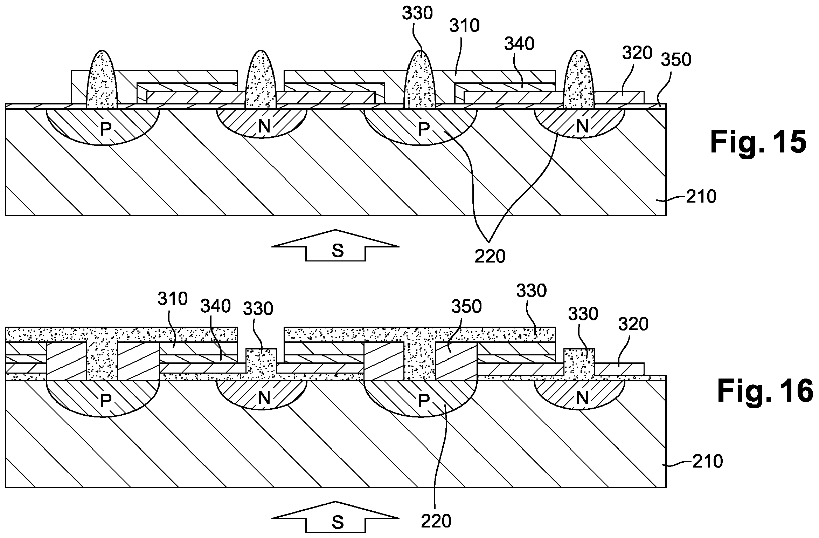

Les figures 15 à 18 représentent des modes de réalisation surfaciques de la batterie, qui correspondent plus aux standards industriels. En particulier, la figure 15 est un équivalent surfacique du mode de réalisation représenté en figure 10. En effet, dans le mode de réalisation de la figure 15, le système photovoltaïque comporte des couches disposées de façon équivalente aux couches de la figure 10 mais empilées les unes sur les autres de sorte à permettre une fabrication plus aisée, par dépose de couches successives

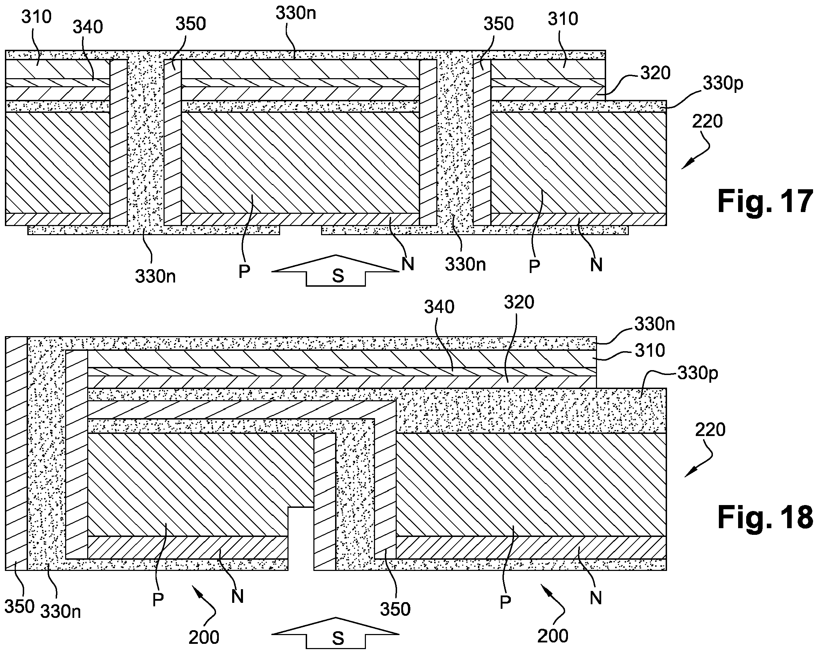

La figure 16 représente un mode de réalisation dans lequel les collecteurs 330 sont eux aussi fabriqués par dépose surfacique, ce qui permet de faciliter encore la fabrication des systèmes photovoltaïques. Dans ce mode de réalisation, différents matériaux sont déposés successivement par couches de sorte à former, au-dessus du substrat 210 contenant les zones dopées 220, les collecteurs 330, les jonctions tunnels 350, l'anode 320, l'électrolyte 340 et la cathode 310. L'invention peut également être mise en oeuvre dans un système photovoltaïque réalisé avec la technologie dite de « Metal Wrap Through ». Dans ce mode de réalisation, représenté sur la figure 17, les collecteurs 330 sont réalisés par dépose surfacique de couches métalliques et la cellule photovoltaïque est obtenue par diffusion sur toute la surface. Le système photovoltaïque forme ainsi un empilement obtenu par déposes de couches successives. Dans ce mode de réalisation, les zones 220 dopées N et dopées P sont empilées l'une sur l'autre, les collecteurs 330 sont empilés de part et d'autre des zones dopées N et P et l'anode 320, l'électrolyte 340 et la cathode 310 sont également empilées sur au moins un des collecteurs. Le collecteur négatif 330n, en contact avec la zone dopée N traverse l'empilement de couches afin de déboucher sur la même face de la cellule photovoltaïque que le collecteur positif 330p en contact avec la zone dopée P. Une jonction tunnel 350 protège le collecteur négatif 330n de tout contact électrique avec l'anode 320, l'électrolyte 340 et le collecteur positif 330p.

La figure 18 représente le même mode de réalisation que la figure 17, mais pour un système photovoltaïque comportant plusieurs cellules photovoltaïques 200 connectées en série et partageant le même contact de la batterie. Bien que ce mode de réalisation ne mette plus en commun qu'une partie des contacts métalliques (ou collecteurs) des cellules et de la batterie, il a l'avantage d'être très proche des standards industriels et donc plus facile à fabriquer.

Lorsque le dispositif de stockage est du type en couches minces, il peut être déposé sur la cellule photovoltaïque ou le module photovoltaïque par induction, sérigraphie, évaporation, électro-dépôt, dépôt chimique en phase vapeur assisté par plasma ou toute autre technique de dépôt de couches utilisée classiquement en microélectronique.

Quel que soit le mode de réalisation, le système photovoltaïque selon l'invention est suffisamment compact pour pouvoir être intégré dans un appareil mobile tel qu'un téléphone mobile, une tablette, un ordinateur portable ou tout autre dispositif électronique portable nécessitant une batterie. L'appareil mobile peut, par exemple, comporter une coque de protection destinée à protéger les composants de l'appareil et dans laquelle le système photovoltaïque de l'invention est intégré. De cette façon, la batterie de l'appareil mobile est rechargée par l'énergie solaire captée par la ou les cellules photovoltaïques.

Bien que décrit à travers un certain nombre d'exemples, variantes et modes de réalisation, le système photovoltaïque selon l'invention comprend divers variantes, modifications et perfectionnements qui apparaîtront de façon évidente à l'homme du métier, étant entendu que ces variantes, modifications et perfectionnements font partie de la portée de l'invention.

## Revendications

1. Système photovoltaïque comportant au moins une cellule photovoltaïque (200) et un dispositif de stockage d'énergie (300) relié électriquement à ladite au moins une cellule photovoltaïque (200), ladite cellule photovoltaïque comportant un substrat semiconducteur (210) dont au moins une zone (220) est dopée positivement et une zone est dopée négativement,
**caractérisé en ce que** le dispositif de stockage d'énergie (300) comporte au moins une anode (320), une cathode (310) et des collecteurs d'énergie (330), lesdits collecteurs (330) du dispositif de stockage constituant également des connexions électriques de la cellule photovoltaïque (200) de sorte que le dispositif de stockage d'énergie est en contact avec la cellule photovoltaïque.

2. Système photovoltaïque selon la revendication 1, **caractérisé en ce que** les zones dopées (220) de ladite cellule photovoltaïque (200) sont en contact direct avec l'anode (320) et la cathode (310) du dispositif de stockage.

3. Système photovoltaïque selon la revendication 1, **caractérisé en ce que** les zones dopées (220) de ladite cellule photovoltaïque sont en contact direct avec les collecteurs d'énergie (330) du dispositif de stockage.

4. Système photovoltaïque selon l'une quelconque des revendications 1 à 3, **caractérisé en ce que** les zones dopées (220) de la cellule photovoltaïque sont au moins partiellement recouvertes d'au moins une jonction tunnel (350).

5. Système photovoltaïque selon la revendication 4, **caractérisé en ce que** le dispositif de stockage (300) comporte un électrolyte (340) entre l'anode (320) et la cathode (310), ledit électrolyte s'étendant entre l'anode et la cathode du dispositif de stockage et les zones dopées (220) de la cellule photovoltaïque de sorte à former au moins une jonction tunnel.

6. Système photovoltaïque selon l'une quelconque des revendications 1 à 5, **caractérisé en ce que** tout ou partie des collecteurs (330) sont positionnés sur une face de la cellule photovoltaïque non-exposée aux rayonnements solaires.

7. Système photovoltaïque selon l'une quelconque des revendications 1 à 6, **caractérisé en ce qu'**il est fabriqué selon la technologie « Metal Wrap Through » ou la technologie « Interdigited Back Contact » ou l'une des technologies en couches minces dites top-down.

8. Système photovoltaïque selon l'une quelconque des revendications 1 à 7, **caractérisé en ce qu'**il comporte au moins une diode anti-retour (353, 354) disposée entre l'anode (320) et/ou la cathode (310) du dispositif de stockage et une zone dopée de la cellule photovoltaïque.

9. Système photovoltaïque selon la revendication 4 ou 8, **caractérisé en ce qu'**il comporte un premier et un second types de jonction tunnel (351, 352) et/ou de diode anti-retour, le premier type étant adapté aux zones dopées positivement (P), le second type étant adapté aux zones dopées négativement (N).

10. Système photovoltaïque selon l'une quelconque des revendications 1 à 9, **caractérisé en ce qu'**il comporte une pluralité de cellules photovoltaïques (200) connectées les unes aux autres et formant un module photovoltaïque.

11. Système photovoltaïque selon la revendication 10, **caractérisé en ce que** la pluralité de cellules photovoltaïques (200) sont connectées en série et que seules une première et une seconde cellules (221, 222) de ladite pluralité sont en contact avec le dispositif de stockage (300).

12. Système photovoltaïque selon l'une quelconque des revendications 1 à 11, **caractérisé en ce qu'**il comporte un circuit imprimé intégré dans le module photovoltaïque en couches minces et met en oeuvre des fonctions électroniques de régulateur.

13. Système photovoltaïque selon l'une quelconque des revendications 1 à 12, **caractérisé en ce que** le dispositif de stockage est déposé sur la cellule photovoltaïque ou le module photovoltaïque par induction, sérigraphie, évaporation, électro-dépôt ou dépôt chimique en phase vapeur assisté par plasma.

14. Appareil mobile, tel qu'un téléphone mobile ou un ordinateur portable, comportant un système photovoltaïque selon l'une quelconque des revendications 1 à 13.

15. Appareil mobile selon la revendication 14, **caractérisé en ce qu'**il comporte une coque apte à protéger ledit appareil, le système photovoltaïque faisant partie intégrante de ladite coque.
